# EUROPEAN PATENT SPECIFICATION

(11) **EP 0 742 442 B1**
(45) Date of publication and mention of the grant of the patent: **13.10.2004**
(21) Application number: 96302809.7
(22) Date of filing: 22.04.1996
(51) Int. Cl.: G01R 21/133, G01R 21/00, G01R 11/24, G01D 4/00

(54) **Improvements in or relating to modulised utility meters**
Verbesserter Elektrizitätszähler
Amélioration de compteurs électriques

(30) Priority: 06.05.1995 GB 9509282
(43) Date of publication of application: 13.11.1996
(73) Proprietor: Landis+Gyr Limited, Telford Shropshire TF1 7YG (GB)
(72) Inventor: Warwick, Ronald, Liverpool L18 2DN (GB)
(74) Representative: Humphrey-Evans, Edward John

(56) References cited:
- EP-A- 0 163 440
- EP-A- 0 598 521
- GB-A- 2 267 156
- GB-A- 2 280 290
- US-A- 4 301 444

## Description

This invention relates to modulised utility meters, and more especially but not exclusively, it relates to modulised electricity meters.

Modulised electricity meters comprise a basic meter module which is operatively associated with an 'add-on' module provided to extend functionality. Such meters are the subject of GB-A-2 295 681, GB-A-2 295 682 and GB-A-2 295 683 (corresponding to British patent application numbers 9424461.3, 9501771.1 and 9501772.9), to which attention is hereby directed.

The 'add-on' module may be fitted to the basic meter module or it may be positioned remote from it so as to be conveniently positioned for receiving credit tokens such as smart cards or the like, for example.

Electricity meters are not uncommonly tampered with by fraudsters intent on obtaining electricity without appropriate payment. In some ways, modulised electricity meters are particularly vulnerable to fraud, since an 'add-on' module may be tampered with without necessarily interfering with the basic meter module.

GB-A-2 280 290 discloses a commodity metering apparatus for combatting fraud when supplying electricity to a consumer. The commodity metering apparatus comprises a fraud unit connected to a consumer unit, the fraud unit meters the supplied energy which is then measured by the consumer unit. The fraud unit is located remote from the consumer unit. The value of electricity consumed which is stored on the fraud unit is compared with that stored on the consumer unit, the consumer unit requesting the fraud unit to transmit its value as encrypted data and once decrypted, a comparison is made. If there is a discrepancy between the value stored on the fraud unit and that stored on the consumer unit, the consumer unit registers a fraud attempt. The fraud and consumer units each contain an ID code and a key which is used to confirm that data relating to the consumption of electricity is genuine, that is, obtained from a particular fraud and consumer unit combination.

It is therefore an object of the present invention to provide a modulised utility meter which is resistant to interference by unauthorised persons for the purposes of fraud.

According to the present invention, there is provided a modulised utility meter comprising:- a basic meter module; basic meter module counter means operatively associated with the basic meter module and arranged to count in dependence upon connection of the basic meter module to the utility; an 'add-on' module; 'add-on' module counter means operatively associated with the 'add-on' module and arranged to count in dependence upon connection of the 'add-on' module to the utility; and comparator means for comparing the count state of the basic meter module counter means and the 'add-on' module counter means and for providing an output signal indicating tampering with the meter in dependence upon the comparison; characterised in that the basic meter module counter means comprises a first continuous counter for counting continuously whilst the basic meter module is coupled to the utility, and a first event counter for counting the number of connections/disconnections of the basic meter module to the utility; and in that the 'add-on' module counter means comprises a second continuous counter for counting continuously whilst the 'add-on' module is coupled to the utility, and a second event counter for counting the number of connections/disconnections of the 'add-on' module to the utility.

The counters may thus be used to provide an indication of the time for which the modules with which they are respectively associated are connected for operation, and therefore, if their differential count state differs from a predetermined expected count state, the output signal will be provided so as to afford an indication that the meter has been tampered with.

Although the comparator may be included as a part of the basic meter module, it is preferably provided in the 'add-on' module.

The output signal may be used to provide a local indication and/or it may be used to provide a remote indication.

In accordance with said one aspect of the invention, the modulised utility meter may be an electricity meter and the two counters may be operatively associated with clock pulse generator means, each counter being arranged to count pulses during periods when electrical power is supplied to the module with which it is operatively associated.

The clock pulse generator means may comprise two timers, one for each module, each timer being arranged to provide clock pulses for the counter of the module with which it is operatively associated.

Each module may be provided with two counters, one of which counts for periods during which electrical power from the utility is present at the module with which it is operatively associated, and the other of which counts disconnections of electrical power from the utility at the module with which it is operatively associated, two comparators being provided which respectively compare the count states of the said one counters which are one pair of corresponding counters, and the count states of the said other counters which are another pair of corresponding counters, thereby to provide from each of the two comparators an output signal in the presence of a predetermined count difference between the count states of corresponding counters, output signals from the two comparators being fed via gate means to provide the output signal.

By using two pairs of counters, which monitor disconnections and time of connection respectively, security may be still further improved or the possibility of false alarms may be reduced.

The gate means may be an OR gate, whereby either of the two comparators will provide the output signal so as to improve security.

Alternatively, the gate means may be an AND gate, whereby the output signal will be provided only in the presence of signals from both comparators so as to reduce the risk of false alarms.

In order to take account of justifiable count differences, which may occur due to system design factors for example, a filter may be included, which serves in effect to modify the said predetermined count differential at which the output signal is provided.

Thus in one contemplated arrangement, an output signal will be delivered only if the count differential changes by more than a predetermined amount.

One embodiment of the invention will now be described by way of example only, with reference to the accompanying drawings, in which,
FIGURE 1 is a generally schematic block circuit diagram of a modulised electricity meter, and wherein,
FIGURE 2 is a somewhat schematic circuit block diagram of a part of the meter shown in Figure 1.

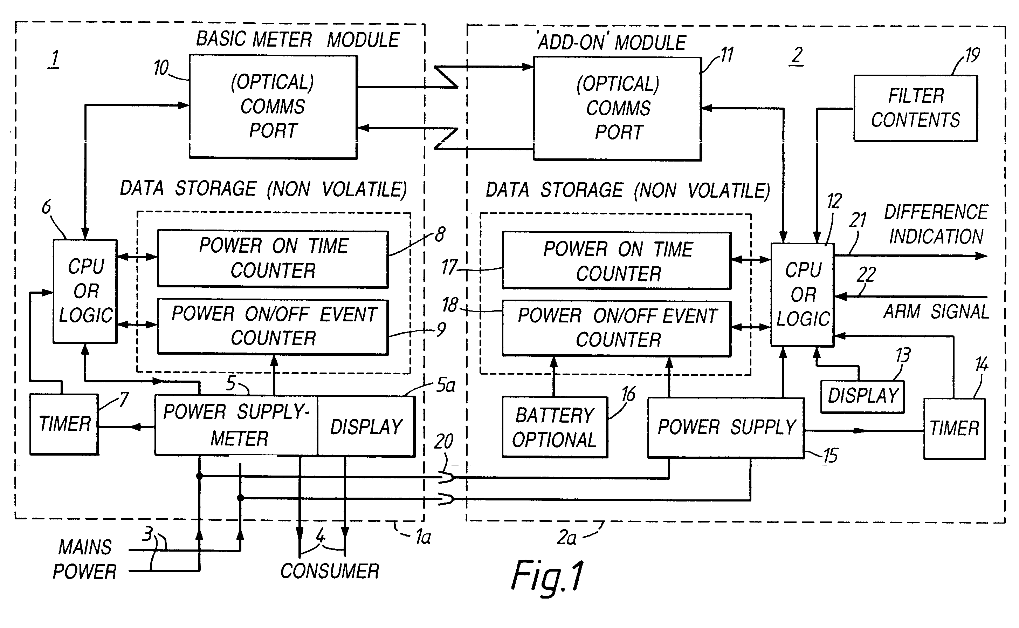

Referring now to Figure 1, a modulised electricity meter comprises a basic meter module 1 as shown within broken line 1a, in operative association with an 'add-on' module 2, which increases functionality and which is shown within broken line 2a. The basic meter module 1 would normally be secured to a wall in a consumer's premises and the 'add-on' module 2 would be mechanically supported by, and electrically connected to the basic meter module 1. The 'add-on' module 2 might perform any one or more of a number of different functions to extend the functionality of the basic meter module 1. For example the 'add-on' module 2 may convert the basic meter module 1 to a prepayment meter, or to a radio telemeter, which can be read and/or controlled remotely for tariff control or billing purposes. The precise function of the basic meter module 1 and the additional functionality afforded by the 'add-on' module 2 are not central to the present invention and accordingly will not be described herein in detail.

The basic meter module 1 receives mains electrical power via input lines 3 from a utility supplier. A consumer is fed with electrical power on lines 4 via a meter 5, which serves to measure the quantity of electricity provided to the consumer, the meter 5 being arranged to include a power supply which serves to provide electrical power at voltages as required for various parts of the basic meter module 1, and a digital display 5a which provides an indication of the quantity of electricity used. The basic meter module 1 additionally comprises a central processor unit (CPU) 6, a timer or clock pulse generator 7, a power on time counter 8, a power on/off event counter 9, and an optical communication port 10. The CPU 6 serves to control operation of the digital display 5a, the counters 8, 9 and the optical communication port 10, in accordance with clock signals provided by the timer 7 and a stored programme which forms part of the CPU 6. The power on time counter 8 is arranged to count pulses from the timer 7 during periods when power is supplied via the lines 3 to the basic meter module 1, and the power on/off event counter 9 is arranged to be incremented each time the power supply on the lines 3 to the basic meter module 1 is interrupted.

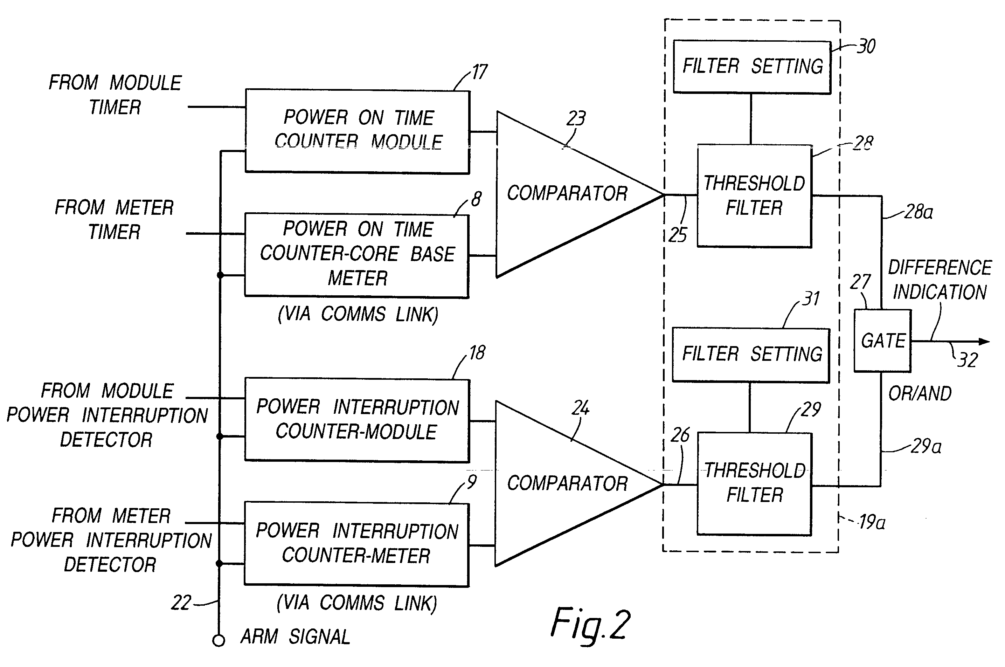

The optical communication port 10 in the basic meter module 1 is arranged to communicate, using light signals, with a corresponding optical communication port 11, in the 'add-on' module 2. Data is transmitted therebetween in accordance with the particular functionality required, which will include data appertaining to the quantity of electricity used and data appertaining to the count state of each of the counters 8 and 9. The 'add-on' module 2 additionally includes a CPU 12, a display 13, a timer 14, a power supply 15, an optional battery 16, a power on time counter 17, a power on/off event counter 18 and a filter 19, which is shown in Figure 2 within broken lines 19a in greater detail. Electrical power from the utility is fed to the power supply 15 via a plug and socket connector 20, which serves electrically to couple the 'add-on' module 2 to the basic meter module 1.

In order to provide the necessary mechanical strength between the two modules 1 and 2, housings (not shown) of the modules 1, 2 may be arranged to mutually interlock, a tamper proof seal (not shown) and screw fixing (not shown) being provided as appropriate. The power supply 15 is arranged to provide the necessary voltages required by the parts of the 'add-on' module 2, and the central processor unit (CPU) 12 is arranged to control operation of the functions afforded by the 'add-on' module 2 in accordance with clock signals provided by the timer 14 and an appropriate stored programme in the CPU 12. The power on time counter 17 is arranged to count pulses from the timer 14 during periods when power is supplied to the 'add-on' module 2 via the connector 20, and the power on event counter 18 is arranged to be incremented each time electrical power supplied via the connector 20 is interrupted.

Thus, it will be appreciated that two pairs of corresponding counters are provided, one counter of each pair being in the basic meter module and the other counter of each pair being in the 'add-on' module. Thus, one pair of corresponding counters, i.e. counters 8 and 17, register power on time, as applied to the module in which they are included, and the other pair of corresponding counters, i.e. counters 9 and 18, register the number of power supply disconnections experienced by the module in which they are included. The CPU 12 is arranged to include a pair of comparators (not shown in Figure 1), which serve to compare the count states of the corresponding counters 8 and 17, and the count states of the corresponding counters 9 and 18, respectively. If the count states of corresponding counters differs by more than a predetermined differential, an output signal is provided on line 21. A predetermined tolerance on the differential is imposed by a filter 19, whereby small count differences which could be accounted for by design variations are taken into account.

In order to facilitate a better understanding of the manner in which the comparators and associated components operate, reference will now be made to Figure 2, wherein parts corresponding to Figure 1 bear the same numerical designations.

At a time of installation of the module, the counters 17, 18, 8 and 9 are reset to a predetermined count state, which might conveniently be zero, by means of an 'arm' signal, which is applied via a line 22 and which might simply serve to reset the counters to zero. The count states of the counters 8 and 17 are compared in a comparator 23 and the count states of the counters 9 and 18 are compared in a comparator 24. If a difference obtains between the count states as monitored by the comparator 23, or the count states as monitored by the comparator 24, an output signal on line 25, from the comparator 23, or line 26 from the comparator 24, will be provided as appropriate. Output signals from the comparators 25 and 26 are fed to a gate 27 via threshold filters 28 and 29, respectively. The thresholds at which signals are passed to the gate 27 from the filters 28 and 29 are controlled by filter setting units 30 and 31, respectively. Thus, it may be arranged that signals from the comparators 23 or 24 do not reach the gate 27 until a predetermined count differential which represents a threshold has been exceeded. In this way, design tolerances can be accounted for, so that false alarms do not occur.

The gate 27 may be an OR gate, whereby an output signals from either of the filters 28 or 29 on lines 28a or 29a, respectively, will be effective to produce a signal on the line 32, or alternatively, the gate 27 may be an AND gate, whereby a signal will be required on both the lines 28a and 29a before an output signal on the line 32 will be provided.

Various modifications may be made to the arrangement just before described, without departing from the scope of the invention and for example, it will be appreciated that one pair of counters may be provided, counting power interruption events experienced by each module and counting the power on time which is appropriate for each module.

It will be appreciated that a system as just before described is particularly resistant to attempts at fraud which might otherwise go undetected.

## Claims

1. A modulised utility meter comprising
a basic meter module (1);
basic meter module counter means (8, 9) operatively associated with the basic meter module (1) and arranged to count in dependence upon connection of the basic meter module (1) to the utility;
an 'add-on' module (2);
'add-on' module counter means (17, 18) operatively associated with the 'add-on' module (2) and arranged to count in dependence upon connection of the 'add-on' module (2) to the utility; and
comparator means (19a,23,24,27,28,29,30,31) for comparing the count state of the basic meter module counters means (8, 9) and the 'add-on' module counter means (17, 18) and for providing an output signal (32) indicating tampering with the meter in dependence upon the comparison;
**characterised in that** the basic meter module counter means (8, 9) comprises a first continuous counter (8) for counting continuously whilst the basic meter module (1) is coupled to the utility, and a first event counter (9) for counting the number of connections/disconnections of the basic meter module (1) to the utility;
and **in that** the 'add-on' module counter means (17, 18) comprises a second continuous counter (17) for counting continuously whilst the 'add-on' module (2) is coupled to the utility, and a second event counter (18) for counting the number of connections/disconnections of the 'add-on' module (2) to the utility, whereby to provide means to indicate that the meter has been tampered with.

2. A modulised utility meter as claimed in Claim 1, wherein the comparator means (19a, 23,24,27,28,29, 30,31) comprises a first comparator (23,28, 30) for comparing the count state of the first and second continuous counters (8, 17), and a second comparator (24, 29, 31) for comparing the count state of the first and second event counters (9, 18), the first and second comparators (23, 24, 28, 29, 30, 31) providing respective first and second signals (28a, 29a) in the presence of a predetermined count difference between the count states of the continuous counters (8, 17) and the event counters (9, 18) respectively.

3. A modulised utility meter as claimed in Claim 2, wherein the comparator means (19a, 23,24,27,28,29, 30,31) further comprises gate means (27) for receiving the first and second signals (28a, 29a) from the first and second comparators (23,24,28,29,30,31) respectively, and for providing the output signal (32).

4. A modulised utility meter as claimed in Claim 3, wherein the gate means (27) comprises an OR gate and either the first signal (28a) or the second signal (29a) provides the output signal (32).

5. A modulised utility meter as claimed in Claim 3, wherein the gate means (27) comprises an AND gate and the output signal (32) is only provided in the presence of both the first signal (28a) and the second signal (29a).

6. A modulised utility meter as claimed im any one of Claims 2 to 5, wherein the comparator means (19a, 23,24,27,28,29,30,31) comprises first and second filters (28, 29) for modifying the predetermined count difference at which the output signal (32) is provided.

7. A modulised utility meter as claimed in Claim 6, wherein the output signal (32) is only delivered if the count difference changes by more than a predetermined amount.

8. A modulised utility meter as claimed in any one of Claims 1 to 7, wherein 'add-on' module (2) is adapted to be continuously received by the basic meter module (1).

9. A modulised utility meter as claimed in Claim 8, wherein each module (1, 2) is provided with an optical communication port (10, 11) controlled by respective central processor units (6, 12) associated with each module (1, 2) for facilinating communication between the basic meter module (1) and the 'add-on' module (2) when the modules (1, 2) are mutually contiguously and operatively associated.

10. A modulised utility meter as claimed in any one of Claims 1 to 9, wherein the comparator means (19a, 23,24,27,28, 29, 30,31) is included as a part of the 'add-on' module (1).

11. A modulised utility meter as claimed in any one of Claims 1 to 10, wherein the output signal (32) is used to provide a local indication.

12. A modulised utility meter as claimed in any one of Claims 1 to 10, wherein the output signal (32) is used to provide a remote indication.

13. A modulised utility meter as claimed in any one of Claims 1 to 12, wherein the modulised utility meter is an electricity meter and further comprises clock pulse generator means (7, 14) operatively associated with the continuous counters (8,17) of each module (1,2), each continuous counter (8,17) being arranged to count pulses during periods when electrical power is supplied to the module (1,2) with which it is operatively associated.

14. A modulised utility meter as claimed in Claim 13, wherein the clock pulse generator means (7, 14) comprises first and second timers (7, 14) associated with respective ones of the basic meter module (1) and the 'add-on' module (2), each timer (7, 14) being arranged to provide clock pulses for the module (1, 2) with which it is operatively associated.

## Patentansprüche

1. Eine modulare Meßeinrichtung bestehend aus:
einem Zählergrundmodul (1);
einer Zählergrundmoduluhr (8, 9) operativ verbunden mit dem Zählergrundmodul (1) und so angeordnet, dass bei einer Verbindung des Zählergrundmoduls (1) mit dem Versorgungsbetrieb die Werte gemessen werden;
einem "Zusatz"-Modul (2);
einer "Zusatz"-Moduluhr (17, 18) operativ verbunden mit dem "Zusatz"-Modul (2) und so angeordnet, dass bei einer Verbindung des "Zusatz"-Moduls (2) mit dem Versorgungsbetrieb die Werte gemessen werden; und
ein Komparator (19a, 23, 24, 27, 28, 29, 30, 31) für den Abgleich des Zählerstandes an der Zählergrundmoduluhr (8, 9) und an der "Zusatz"-Moduluhr (17, 18), welcher gleichzeitg ein Leistungssignal (32) abgibt, wenn der Abgleich der Messungen Hinweise auf einen betrügerischen Eingriff erkennen lassen;
wobei das Besondere darin besteht, dass die Zählergrundmoduluhr (8, 9) einen ersten Zähler (8) enthält, der kontinuierlich misst während das Zählergrundmodul (1) mit dem Versorgungsbetrieb verbunden ist, sowie einen ersten Schaltüberwacher (9), der den Verbindungsaufbau/Verbindungsabbau zwischen dem Zählergrundmodul (1) und dem Versorgungsbetrieb nachhält;
und weiterhin, dass die "Zusatz"-Moduluhr (17, 18) eine zweite Meßeinrichtung (17) aufweist, die, während das Zusatz"-Modul (2) mit dem Versorgungsbetrieb verbunden ist, kontinuierlich misst, sowie einen zweiten Schaltüberwacher (18), der den Verbinclungsaufbau/Verbindungsabbau zwischen dem "Zusatz"-Modul (2) und dem Versorgungsbetrieb nachhält, wodurch erkennbar wird, wenn ein betrügerischer Eingriff am Zähler stattgefunden hat.

2. Eine modulare Meßeinrichtung, wie in Patentanspruch 1 dargelegt, bei der ein Komparator-Aggregat (19a, 23, 24, 27, 28, 29, 30, 31) einen ersten Komparator (23, 28, 30) enthält für den Abgleich der Messergebnisse der ersten und zweiten Meßeinrichtung (8, 17), sowie einen zweiten Komparator (24, 29, 31) für den Abgleich der Messergebnisse des ersten und zweiten Schaltüberwachers (9, 18), wobei der erste und zweite Komparator (23, 24, 28, 29, 30, 31) im Falle von Messabweichungen zwischen dem Ergebnis der Messeinrichtungen (8, 17) und den Schaltüberwachem (9, 18) jeweils das erste bzw. zweite Signal (28a, 29a) auslösen.

3. Eine modulare Meßeinrichtung, wie in Patentanspruch 2 dargelegt, bei der der Komparator (19a, 23, 24, 27, 28, 29, 30, 31) weiterhin mit einem Auftaktimpuls (27) für den Empfang des ersten bzw. zweiten Signals (28a, 29a) vom ersten bzw. zweiten Komparator (23, 24, 28, 29, 30, 31) sowie für und das Auslösen eines entsprechenden Leistungssignals (32) ausgerüstet ist.

4. Eine modulare Meßeinrichtung, wie in Patentanspruch 3 dargelegt, bei der der Auftaktimpuls (27) eine ODER Funktion aufweist, so dass entweder das erste Signal (28a) oder das zweite Signal (29a) das Leistungssignal (32) auslöst.

5. Eine modulare Meßeinrichtung, wie in Patentanspruch 3 dargelegt, bei der der Auftaktimpuls (27) eine UND Funktion aufweist, so dass das Leistungssignal (32) nur dann ausgelöst wird, wenn sowohl das erste Signal (28a) wie auch das zweite (29a) vorhanden sind.

6. Eine modulare Meßeinrichtung, wie in Patenanspruch 2 bis 5 dargelegt, bei der der Komparator (19a, 23, 24, 27, 28, 29, 30, 31) einen ersten und zweiten Filter (28, 29) aufweist für die Modifizierung des vorbestimmten Meßunterschieds, bei dem das Leistungssignal (32) ausgelöst wird.

7. Eine modulare Meßeinrichtung, wie in Patentanspruch 6 dargelegt, bei der das Leistungssignal (32) nur dann ausgelöst wird, wenn sich der Meßunterschied um mehr als die vorbestimmten Werte ändert.

8. Eine modulare Meßeinrichtung, wie in Patentanspruch 1 bis 7 dargelegt, bei der ein "Zusatz"-Modul (2) so adaptiert ist, daß es kontinuierlich vom Zählergrundmodul (1) empfangen werden kann.

9. Eine modulare Meßeinrichtung, wie in Patentanspruch 8 dargelegt, bei der jedes Modul (1, 2) mit einem optischen, von zentralen Prozessor-Einheiten (6, 12) überwachten Anschluss (10, 11) ausgerüstet und verbunden ist, um die Kommunikation zwischen dem Zählergrundmodul (1) und dem "Zusatz"-Modul (2) zu ermöglichen, wenn die Module (1, 2) lückenlos und operativ miteinander verbunden sind.

10. Eine modulare Meßeinrichtung, wie in Patentanspruch 1 bis 9 dargelegt, bei der der Komparator (19a, 23, 24, 27, 28, 29, 30, 31) Bestandteil des "Zusatz"-Moduls (1) ist.

11. Eine modulare Meßeinrichtung, wie in Patentanspruch 1 bis 10 dargelegt, bei der das Ausgabesignal (32) zur Anzeige vor Ort benutzt wird.

12. Eine modulare Meßeinrichtung, wie in Patentanspruch 1 bis 10 dargelegt, bei der das Ausgabesignal (32) zur Anzeige an anderer Stelle benutzt wird.

13. Eine modulare Meßeinrichtung, wie in Patentanspruch 1 bis 12 dargelegt, bei der die modulare Meßeinrichtung ein Stromzähler ist und weiterhin über einen Taktimpulsgeber (7, 14) verfügt, operativ verbunden mit den Zählern (8, 17) eines jeden Moduls (1, 2), wobei jeder dieser Zähler (8, 17) so angeordnet ist, daß der Takt während der Zeiten der Strombelieferung an das mit ihm operativ verbundene Modul (1, 2) gemessen wird.

14. Eine modulare Meßeinrichtung, wie in Patentanspruch 13 dargelegt, bei der der Taktimpulsgeber (7, 14) aus einer ersten und zweiten Uhr (7, 14) besteht, verbunden mit dem des jeweiligen Zählergrundmoduls (1) und des "Zusatz"-Moduls (2), wobei jede Uhr (7, 14) so angeordnet ist, dass sie Taktimpulse für das mit ihr operativ verbundene Modul (1, 2) gibt.

## Revendications

1. Un compteur fonctionnel à modules comprenant:
un module de compteur de base (1)
un moyen de comptage (8,9) du module de compteur de base, associé opérationnellement au module (1) du compteur de base et disposé pour compter s'il y a connexion du module (1) du compteur de base avec le compteur fonctionnel;
un module additionnel (2);
un moyen de comptage (17,18) du module additionnel associé opérationnellement au module additionnel (2) et disposé de façon à compter s'il y a connexion du module additionnel (2) au compteur fonctionnel; et
un comparateur (19a, 23,24,27,28,29,30,31) pour comparer l'état de compte du moyen de comptage (8, 9) du module du compteur de base et du moyen de comptage (17, 18) du module additionnel et pour fournir un signal de sortie (32) indiquant une falsification du compteur résultant de la comparaison;
**caractérisé en ce que** le moyen de comptage (8, 9) du module de compteur de base comprend un premier compteur continu (8) pour compter en continu pendant que le module (1) du compteur de base est accouplé au compteur fonctionnel, et un compteur de premier événement (9) pour compter le nombre de connections/déconnections du module (1) de compteur de base au compteur fonctionnel;
et **en ce que** les moyens (17,18) du module de compteur additionnel comprennent un deuxième compteur continu (17) pour compteur en continu tandis que le module additionnel (2) est accouplé au compteur fonctionnel, et un deuxième compteur d'événement (18) pour compter le nombre de connections/déconnections du module additionnel (2) au compteur fonctionnel, fournissant ainsi des moyens pour indiquer que le compteur a été falsifié.

2. Un compteur fonctionnel à modules selon la revendication 1, dans lequel le moyens comparateurs (19a, 23,24,27,28, 29,30,31) comprennent un premier comparateur (23,28,30) pour comparer l'état de compte du premier et du deuxième compteur continu (8,17) et un deuxième comparateur (24,29,31) pour comparer l'état de compte du premier et du deuxième compteur d'événement (9,18), le premier et le deuxième comparateur (23,24,28,29,30,31) fournissant respectivement un premier et un deuxième signal (28a,29a) quand ils constatent la présence d'une différence avec le compte prédéterminé entre les états de compte des compteurs continus (8,17) et les compteurs d'événements (9, 18) respectivement.

3. Un compteur fonctionnel à modules selon la revendication 2, dans lequel les moyens comparateurs (19a, 23, 24, 27,28,29,30,31) comprennent de surcroît une porte (27) pour recevoir le premier et le deuxième signal (28a,29a) émanant du premier et du deuxième comparateur (23,24,28,29,30,31) respectivement, et pour fournir le signal de sortie (32).

4. Un compteur fonctionnel à modules selon la revendication 3, dans lequel la porte (27) comprend une porte OU et le signal de sortie (32).est fourni soit par le premier signal (28a) ou par le deuxième signal (29a).

5. Un compteur fonctionnel à modules selon la revendication 3, dans lequel la porte (27) comprend une porte ET et le signal de sortie (32) n'est fourni qu'en présence des deux signaux, le premier (28a) et le deuxième (29a).

6. Un compteur fonctionnel à modules selon l'une quelconque des revendications 2 à 5, dans lequel les moyens comparateurs (19a,23,24,27,29,30,31) comprennent un premier et un deuxième filtre (28,29) pour modifier la différence de compte prédéterminée à laquelle le signal de sortie (32) est prévu.

7. Un compteur fonctionnel à modules selon la revendication 6, dans lequel le signal de sortie (32) n'est émis que si la différence de compte change de plus d'une quantité prédéterminée.

8. Un compteur fonctionnel à modules selon l'une quelconque des revendications 1 à 7, dans lequel le module additionnel (2) est adapté pour être reçu en continu par le module (1) du compteur de base.

9. Un compteur fonctionnel à modules selon la revendication 8, dans lequel chaque module (1,2) est prévu avec un orifice de communication optique (10, 11) contrôlé par des éléments (6,12) d'unité centrale de traitement respectivement, associés à chaque module (1,2) pour faciliter la communication entre le module (1) du compteur de base et le module (2) additionnel quand les modules (1, 2) sont mutuellement associés de façon contiguë et opérationnelle.

10. Un compteur fonctionnel à modules selon l'une quelconque des revendications 1 à 9, dans lequel les moyens comparateurs (19a, 23,24,27,28,29,30,31) sont compris comme partie du module additionnel (1).

11. Un compteur fonctionnel à modules selon l'une quelconque des revendications 1 à 10, dans lequel le signal de sortie (32) est utilisé pour fournir une indication locale.

12. Un compteur fonctionnel à modules selon l'une quelconque des revendications 1 à 10, dans lequel le signal de sortie (32) est utilisé pour fournir une indication à distance.

13. Un compteur fonctionnel à modules selon l'une quelconque des revendications 1 à 12, dans lequel le compteur fonctionnel à modules est un compteur d'électricité et comprend de surcroît un moyen générateur d'impulsion d'horloge (7,14) associé opérationnellement aux compteurs continus (8, 17) de chaque module (1,2), chaque compteur continu (8,17) étant prévu pour compter les impulsions pendant les périodes pendant lesquelles l'énergie électrique est fournie au module (1,2) auquel il est associé opérationnellement.

14. Un compteur fonctionnel à modules selon la revendication 13, dans lequel le moyen de génération de signal d'horloge (7, 14) comprend un premier et un deuxième minuteur (7,14) associés respectivement au module (1) du compteur de base et au module (2) additionnel, chaque minuteur (7,14) étant prévu pour fournir des impulsions d'horloge pour les modules (1,2) auxquels il est associé opérationnellement.
